# EUROPEAN PATENT APPLICATION

(11) **EP 4 459 673 A1**
(43) Date of publication of application: **06.11.2024**
(21) Application number: 22912956.4
(22) Date of filing: 25.02.2022
(51) Int. Cl.: H01L 23/02, H01L 23/48, H01L 23/52, H01L 21/82, H01L 21/768

(54) **PACKAGING STRUCTURE AND INTEGRATED CIRCUIT BOARD**

(30) Priority: 29.12.2021 CN 202111643128
(71) Applicant: SANECHIPS TECHNOLOGY CO., LTD., Shenzhen, Guangdong 518055 (CN)
(72) Inventor: JIANG, Qiang, Shenzhen, Guangdong 518057 (CN); LI, Leqi, Shenzhen, Guangdong 518057 (CN); WANG, Zongwei, Shenzhen, Guangdong 518057 (CN); PANG, Jian, Shenzhen, Guangdong 518057 (CN); SUN, Tuobei, Shenzhen, Guangdong 518057 (CN)
(74) Representative: Ipsilon
(86) International application number: PCT/CN2022/078103
(87) International publication number: WO 2023/123650

(57) **Abstract**

The embodiments of the present application relate to the technical field of integrated circuit packaging. Provided are a packaging structure and an integrated circuit board. The packaging structure includes: a substrate having a plurality of first conductive layers (101) and a plurality of second conductive layers (102), where the first conductive layers (101) and the second conductive layers (102) have different electric property types; a redistribution structure (104) including redistribution layers (110) at a plurality of layers and arranged at intervals, wherein the redistribution layers (110) located at the same layer have the same electric property type, and the redistribution layers (110) located at adjacent layers have different electric property types; and a plurality of conductive bumps (140) electrically connected to the first conductive layers (101) or the second conductive layers (102) through the redistribution structure (104).

## Description

### CROSS-REFERENCE TO RELATED APPLICATIONS

The present application is based on and claims the priority to Chinese patent application No. 202111643128.6 filed on December 29, 2021, the entire disclosure of which is incorporated in the present application by reference.

### TECHNICAL FIELD

Embodiments of the present application relate to the technical field of integrated circuit packaging, and particularly relate to a packaging structure and an integrated circuit board.

### BACKGROUND

Integrated circuit packaging is an important production process in the technical field of integrated circuits, and the development of related computer technologies and communication technologies in recent years has put higher demands on integrated circuit packaging. That is, the integrated circuit package is desired to be smaller, thinner, lighter, more reliable, multifunctional, and involves lower power consumption and cost. Since the two-dimensional packaging density has reached the theoretical maximum, 2.5D packaging and three-dimensional packaging (3D packaging) of higher density are emerging.

The 2.5D packaging can package processors, memories and other modules under different processes together, which avoids an increased size of the chip and reduction of the yield, while enabling selections of modules based on functions, and reducing the development cost. In the 2.5D packaging, a redistribution structure may be used to carry a plurality of chips upward and interconnected with a package substrate downward, which achieves chip interconnection and fans out a signal power to the package substrate, but also has a series of problems, such as poor reliability of the redistribution structure.

### SUMMARY

An embodiment of the present application provides a packaging structure, including: a substrate having a plurality of first conductive layers and a plurality of second conductive layers, wherein the first conductive layers and the second conductive layers have different electric property types, and the electric property types include a first electric property type and a second electric property type; a redistribution structure on the substrate and including: redistribution layers at a plurality of layers and arranged at intervals, wherein the redistribution layers located at the same layer have the same electric property type, and the redistribution layers located at adjacent layers have different electric property types; and wherein the first conductive layers are electrically connected to each of the redistribution layers having the first electric property type through first conductive pillars, and the second conductive layers are electrically connected to each of the redistribution layers having the second electric property type through second conductive pillars; and a plurality of conductive bumps on a surface of the redistribution structure away from the substrate and electrically connected to the first conductive layers or the second conductive layers through the redistribution structure.

An embodiment of the present application further provides an integrated circuit board, including: any packaging structure as described herein.

### BRIEF DESCRIPTION OF DRAWINGS

FIG. 1 is a schematic perspective view of a packaging structure according to an embodiment of the present application;
FIG. 2 is a schematic structural diagram of a packaging structure according to an embodiment of the present application;
FIG. 3 is another schematic structural diagram of a packaging structure according to an embodiment of the present application;
FIG. 4 is yet another schematic structural diagram of a packaging structure according to an embodiment of the present application;
FIG. 5 is still another schematic structural diagram of a packaging structure according to an embodiment of the present application;
FIG. 6 is a schematic sectional view of a packaging structure taken along A-A, according to an embodiment of the present application;
FIG. 7 is an enlarged view of a partial sectional structure A1 of a packaging structure according to an embodiment of the present application;
FIG. 8 is an enlarged view of a partial sectional structure A2 of a packaging structure according to an embodiment of the present application;
FIG. 9 is a schematic structural diagram of a first redistribution layer according to an embodiment of the present application;
FIG. 10 is a schematic structural diagram of a first surface of a first redistribution layer according to an embodiment of the present application;
FIG. 11 is a schematic structural diagram of a second surface of a first redistribution layer according to an embodiment of the present application;
FIG. 12 is a schematic structural diagram of a second redistribution layer according to an embodiment of the present application;
FIG. 13 is a schematic structural diagram of a first surface of a second redistribution layer according to an embodiment of the present application;
FIG. 14 is a schematic structural diagram of a second surface of a second redistribution layer according to an embodiment of the present application;
FIG. 15 is a schematic structural diagram of a third redistribution layer according to an embodiment of the present application;
FIG. 16 is a schematic structural diagram of a first surface of a third redistribution layer according to an embodiment of the present application;
FIG. 17 is a schematic structural diagram of a second surface of a third redistribution layer according to an embodiment of the present application;
FIG. 18 is an enlarged view of a third redistribution layer at B according to an embodiment of the present application;
FIG. 19 is a partial sectional view of a third redistribution layer taken along C-C according to an embodiment of the present application;
FIG. 20 is a schematic structural diagram of a fourth redistribution layer according to an embodiment of the present application;
FIG. 21 is a schematic structural diagram of a first surface of a fourth redistribution layer according to an embodiment of the present application;
FIG. 22 is a schematic structural diagram of a second surface of a fourth redistribution layer according to an embodiment of the present application;
FIG. 23 is a schematic structural diagram of a fifth redistribution layer according to an embodiment of the present application;
FIG. 24 is a schematic structural diagram of a first surface of a fifth redistribution layer according to an embodiment of the present application;
FIG. 25 is a schematic structural diagram of a second surface of a fifth redistribution layer according to an embodiment of the present application; and
FIG. 26 is a schematic flowchart of a packaging method according to an embodiment of the present application.

### DETAIL DESCRIPTION OF EMBODIMENTS

A main object of the embodiments of the present application is to provide a packaging structure and an integrated circuit board which can at least solve the problem of poor reliability of the redistribution structure.

An embodiment of the present application provides a packaging structure, including: a substrate having a plurality of first conductive layers and a plurality of second conductive layers, where the first conductive layers and the second conductive layers have different electric property types, and the electric property types include a first electric property type and a second electric property type; a redistribution structure on the substrate and including: redistribution layers at a plurality of layers and arranged at intervals, where the redistribution layers located at the same layer have the same electric property type, and the redistribution layers located at adjacent layers have different electric property types; and where the first conductive layers are electrically connected to each of the redistribution layers having the first electric property type through first conductive pillars, and the second conductive layers are electrically connected to each of the redistribution layers having the second electric property type through second conductive pillars; and a plurality of conductive bumps on a surface of the redistribution structure away from the substrate, where the conductive bumps are electrically connected to the first conductive layers or the second conductive layers through the redistribution structure. The redistribution layers located at adjacent layers having different electric property types means that the redistribution layers of different electric property types are alternately arranged. In other words, a redistribution layer of a different electric property type is provided between the redistribution layers of the same electric property type, to reduce the crosstalk between upper and lower surfaces of the redistribution layers, while an interlayer spacing of the redistribution layers of different electric property types is reduced to facilitate impedance control, interlayer coupling and shielding. Therefore, the capacitance of the redistribution layers is favorably reduced, noises are effectively filtered to balance the voltage, and the reliability of the redistribution structure is improved. The redistribution layers located at the same layer having the same electric property type can avoid interlayer crosstalk of different electric property types in the same redistribution layer.

To make the objects, technical solutions and advantages of the embodiments of the present application clearer, embodiments of the present application will be described in detail below with reference to the accompanying drawings. However, it will be appreciated by those of ordinary skill in the art that numerous technical details are set forth in various embodiments of the present application to provide a better understanding of the present application. However, the technical solutions claimed in the present application can be implemented even without these technical details or based on various changes and modifications based on the following embodiments. The following embodiments are divided for convenience of description, and should not constitute any limitation to the specific implementation of the present application, and the embodiments may be mutually incorporated and referred to without contradiction.

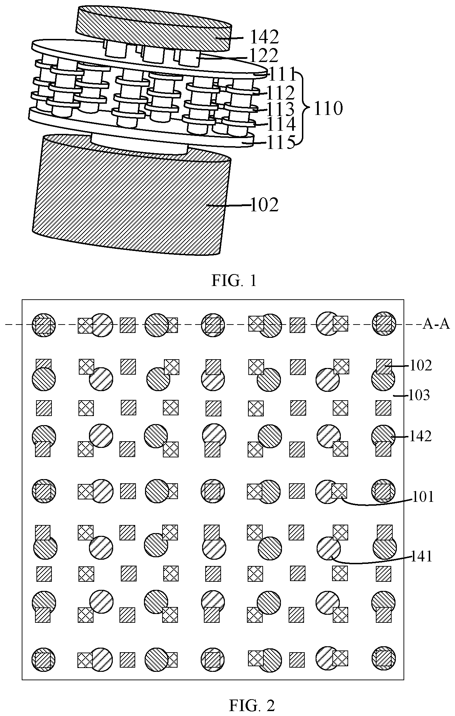

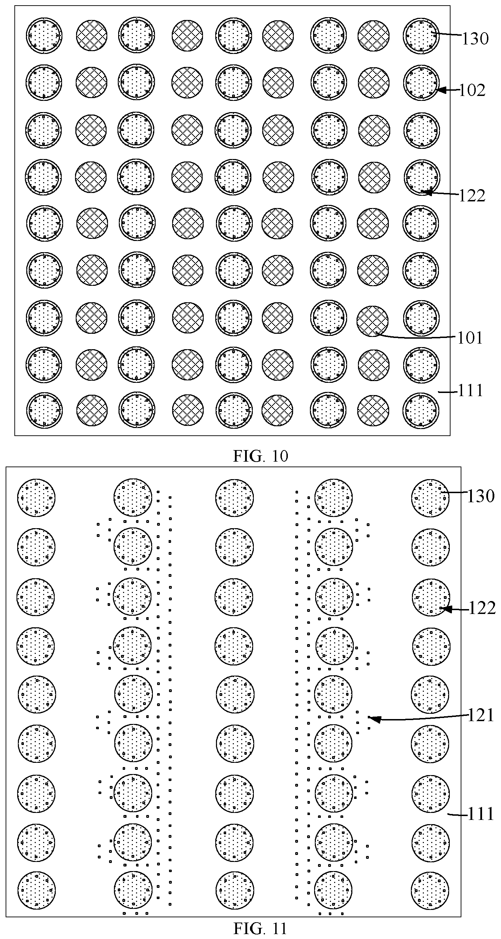

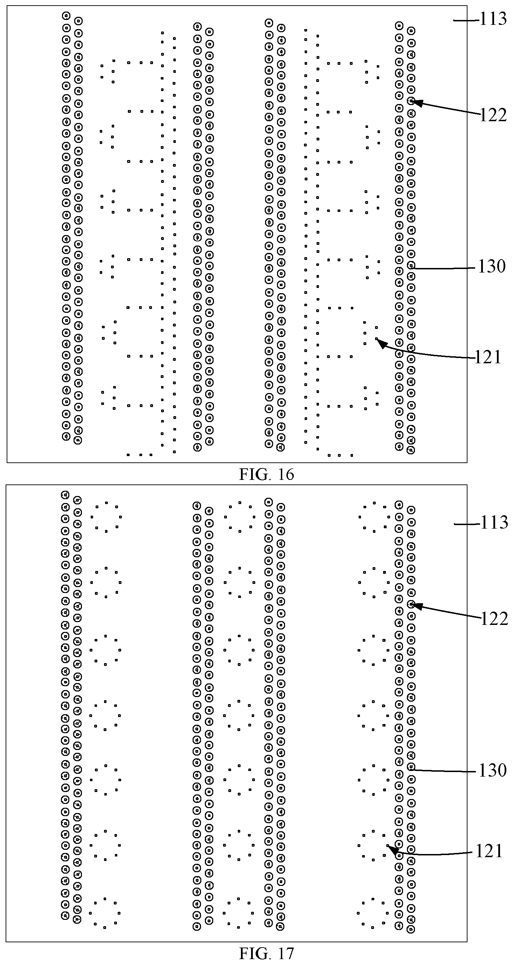

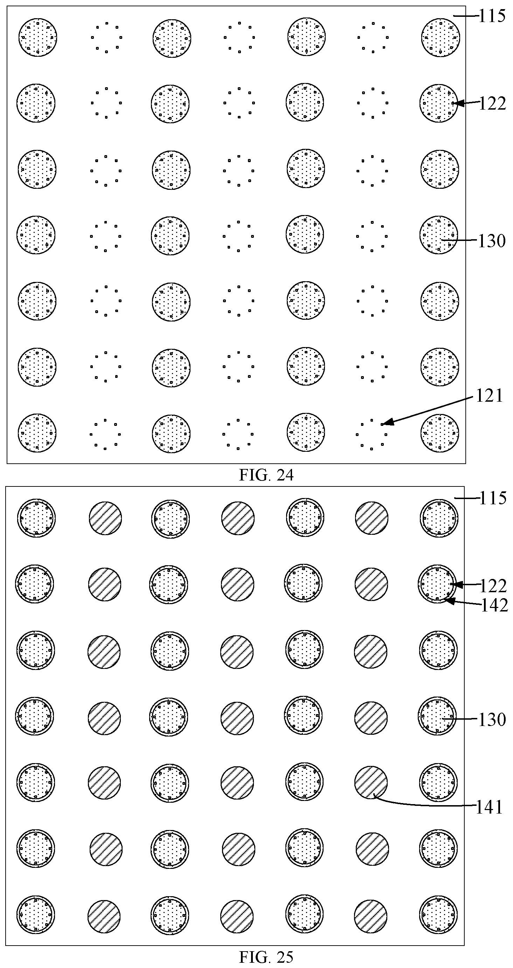

It should be noted that in order to show positions and connection relationships of the first conductive layers, the second conductive layers, and the conductive bumps, the insulation layer in FIGs. 1 to 5 is in a perspective state, that is, the inside of the insulation layer is visible or a top or bottom of the insulation layer is visible through the insulation layer. The redistribution structure in FIGs. 2 to 5 is in a perspective state, that is, the inside of the redistribution structure is visible or a bottom of the redistribution structure is visible through the redistribution structure. To show the connection relationships between the first conductive layers and the conductive bumps, and between the second conductive layers and the conductive bumps, the redistribution layer in FIGs. 1 to 25 is not distinguished from the first conductive pillar and the second conductive pillar, that is, the redistribution layer, the first conductive pillar and the second conductive pillar in the drawings may be regarded as an integral structure. The first surface is a surface of the redistribution structure facing the substrate, and the second surface is a surface of the redistribution structure away from the substrate.

Referring to FIGs. 1 to 25, the packaging structure includes: a substrate (not shown in the figure) having a plurality of first conductive layers 101 and a plurality of second conductive layers 102, where the first conductive layers 101 and the second conductive layers 102 have different electric property types, and the electric property types include a first electric property type and a second electric property type; a redistribution structure 104 on the substrate and including: redistribution layers 110 at a plurality of layers and arranged at intervals, where the redistribution layers 110 located at the same layer have the same electric property type, and the redistribution layers 110 located at adjacent layers have different electric property types; and where the first conductive layers 101 are electrically connected to each of the redistribution layers 110 having the first electric property type through first conductive pillars 121, and the second conductive layers 102 are electrically connected to each of the redistribution layers 110 having the second electric property type through second conductive pillars 122; and a plurality of conductive bumps 140 on a surface of the redistribution structure 104 away from the substrate, where the conductive bumps 140 are electrically connected to the first conductive layers 101 or the second conductive layers 102 through the redistribution structure 104.

The 2.5D packaging may include integrated fan-out (InFO) and chip-on-wafer-on-substrate (CoWoS). In some embodiments, the packaging structure is based on an InFO package and a CoWoS package, where a package substrate is added, i.e., integrated fan-out on-substrate (InFO_oS), so as to enable application to a high performance computing (HPC) cluster, and in the InFO_oS, a plurality of chips are connected to the package substrate through a redistribution layer (RDL).

In some embodiments, the substrate may have a single-layer structure or a stacked structure, and may be provided with electrical devices such as transistors, resistors, or capacitors, while the first conductive layers 101 and the second conductive layers 102 may be electrically connected to ports of the electrical devices through various conductive structures (not shown). The substrate is provided with an insulation layer 103, in which a redistribution structure 104 is positioned. The insulation layer 103 is made of an insulating material, and configured to electrically isolate, and reduce a parasitic capacitance between, the plurality of first conductive layers 101 and the plurality of second conductive layers 102. The insulation layer 103 may be made of any one of silicon oxide, silicon nitride, or silicon carbide.

The first conductive layers 101 and the second conductive layers 102 may be used as microbumps (µ bumps) for applying an operating voltage/current and deriving or outputting a test voltage/current. A relatively small spacing, for example, 36um, may be provided between the microbumps, so that more I/Os can be implemented in the packaging structure to increase the operation speed of the chip. The microbumps may be from different chips or wafers, and the microbumps on different chips may have different spacings. In other words, the plurality of first conductive layers 101 and the plurality of second conductive layers 102 may be from different chips, and the first conductive layers 101 and the second conductive layers 102 on different chips may have different spacings. The substrate includes a first initial substrate, a second initial substrate, and a third initial substrate. For example, the microbumps on the first chip have a spacing of 110um, the microbumps on the second chip have a spacing of 130um, and the microbumps on the third chip have a spacing of 210um. Exemplarily, the plurality of first conductive layers 101 and the plurality of second conductive layers 102 on the same chip are equally spaced. In other embodiments, in the same chip, a spacing between any first conductive layer 101 and the corresponding second conductive layer 102 thereof is different from a spacing between an adjacent first conductive layer 101 and the corresponding second conductive layer 102 thereof.

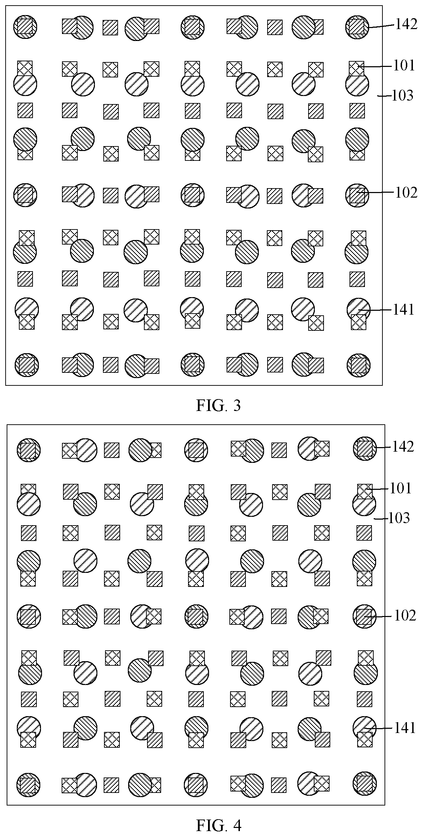

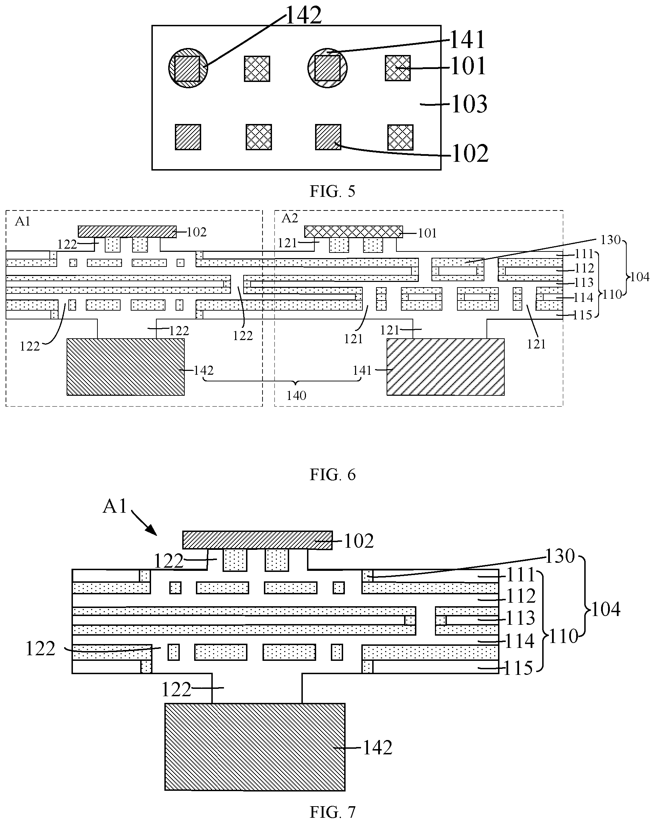

The first conductive layers 101 and the second conductive layers 102 are alternately arranged at intervals to balance the voltage. In some embodiments, as shown in FIG. 3, the first conductive layers 101 and the second conductive layers 102 are alternately arranged at intervals in a lateral direction, while the same conductive layers are arranged in a longitudinal direction. In other embodiments, as shown in FIG. 4, the same conductive layers are arranged in the lateral direction, while the first conductive layers 101 and the second conductive layers 102 are alternately arranged at intervals in the longitudinal direction. In still some embodiments, as shown in FIG. 5, the first conductive layers 101 and the second conductive layers 102 are alternately arranged at intervals in both the lateral direction and the longitudinal direction.

In some embodiments, the first conductive layers 101 and the second conductive layers 102 may be made of the same material, which may be aluminum, tungsten, and copper that have a relatively low self-resistance, which is beneficial to improving the conductivity of the first conductive layers 101 and the second conductive layers 102, and thus is beneficial to improving the conductivity of the first conductive layers 101 and the second conductive layers 102 with the redistribution structure 110.

In some embodiments, the first electric property type is ground property, and the second electric property type is power property. That is, the first conductive layers 101 have a ground property, and the second conductive layers 102 have a power property. In other embodiments, the first electric property type is power property, and the second electric property type is ground property.

The number of layers of redistribution layers 110 is greater than or equal to 3; and the electric property type of one of the redistribution layer 110 farthest from the substrate is ground property, which is beneficial to reducing a path impedance of the supply current. Further, the redistribution layers 110 having the ground property may be used to shield inner layer signal radiation. In some embodiments, the redistribution layers 110 include a first redistribution layer 111, a second redistribution layer 112, a third redistribution layer 113, a fourth redistribution layer 114 and a fifth redistribution layer 115 arranged in a stack. The first redistribution layer 111, the third redistribution layer 113 and the fifth redistribution layer 115 have the first electric property type, and the second redistribution layer 112 and the fourth redistribution layer 114 have the second electric property type. In other words, the first redistribution layer 111, the third redistribution layer 113 and the fifth redistribution layer 115 have a ground property, and the second redistribution layer 112 and the fourth redistribution layer 114 have a power property. Since the redistribution layers 110 having the ground property can better absorb electromagnetic waves, the redistribution layers 110 having the ground property are positioned on upper and lower surfaces of the redistribution layers 110 having the power property, which is beneficial to reducing a path impedance of the supply current. Further, the redistribution layers 110 having the ground property may be used to shield inner layer signal radiation.

In some embodiments, as shown in FIGs. 6 to FIG. 25, the first conductive layers 101 are electrically connected to the first redistribution layer 111, the third redistribution layer 113 and the fifth redistribution layer 115 through first conductive pillars 121, and the second conductive layers 102 are electrically connected to the second redistribution layer 112 and the fourth redistribution layer 114 through second conductive pillars 122. The redistribution layers 110 may be made of any one or more of aluminum, titanium, or titanium nitride. Aluminum, titanium, or titanium nitride has lower hardness and is easy to operate in the subsequent packaging, while saving the cost compared with redistribution layers 110 made of gold. The first conductive pillars 121 and the second conductive pillars 122 may be made of the same material as the redistribution layers 110.

In some embodiments, the redistribution structure 104 further includes: an isolation layer 130 between the redistribution layers 110 located at adjacent layers, between the first conductive pillars 121 and a redistribution layer having the second electric property type, and between the second conductive pillars 122 and a redistribution layer having the first electric property type. As shown in FIGs. 6 to 25, the isolation layer 130 is located between the first redistribution layer 111 and the second redistribution layer 112, between the second redistribution layer 112 and the third redistribution layer 113, between the third redistribution layer 113 and the fourth redistribution layer 114, and between the fourth redistribution layer 114 and the fifth redistribution layer 115. The isolation layer 130 is further located between the first conductive pillars 121 and the second redistribution layer 112, between the first conductive pillars 121 and the fourth redistribution layer 114, between the second conductive pillars 122 and the first redistribution layer 111, between the second conductive pillars 122 and the third redistribution layer 113, and between the second conductive pillars 122 and the fifth redistribution layer 114. The isolation layer 130 is configured to electrically isolate the redistribution layers 110 located at the adjacent layers, and may be made of an insulating material such as silicon nitride, silicon oxide, silicon carbide, or other high-k materials.

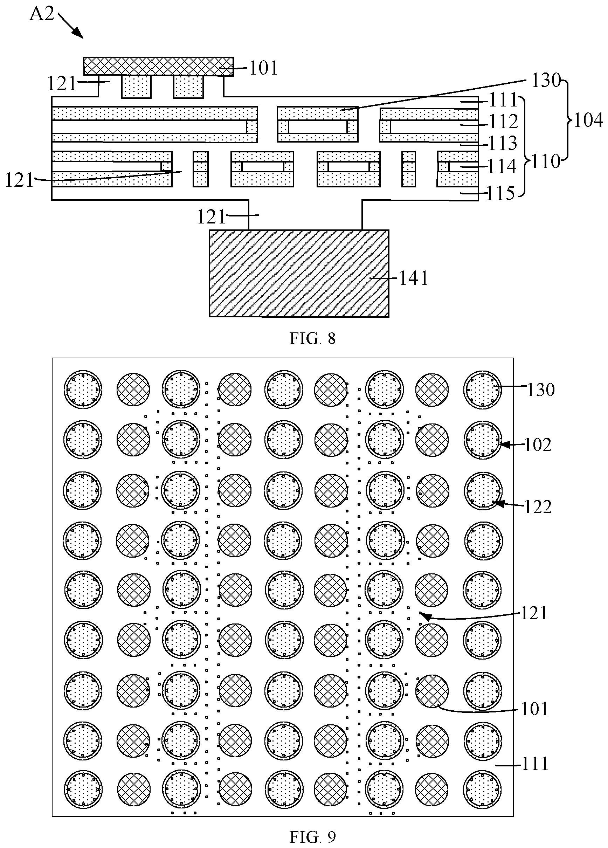

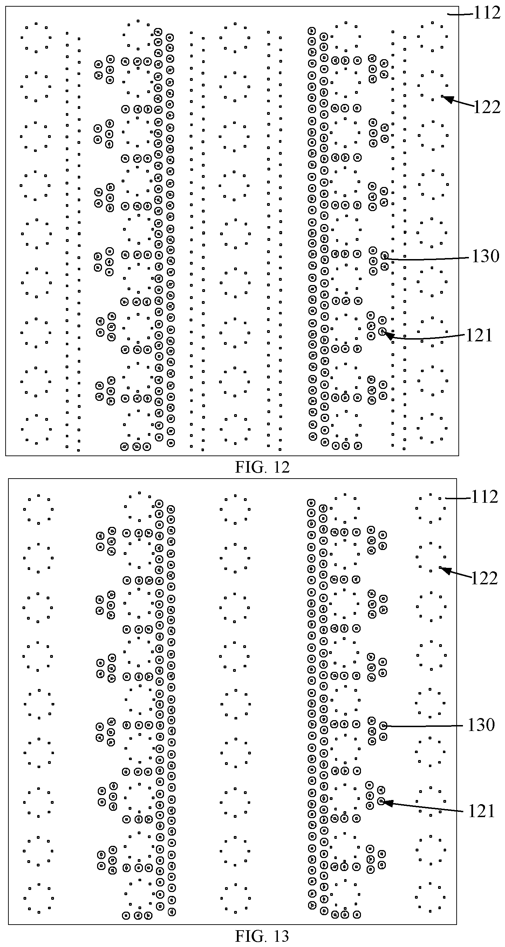

In some embodiments, the first conductive pillars 121 and the second conductive pillars 122 may be arranged in the manner shown in FIGs. 6 to 25. Referring to FIGs. 9 to 11, the first conductive layer 101 is electrically connected to a first surface of the first redistribution layer 111 through the first conductive pillars 121, each second conductive layer 102 is electrically connected to a first surface of the second redistribution layer 112 through eight second conductive pillars 122 passing through the first redistribution layer 111 in a thickness direction thereof (see FIGs. 12 to 14), and a second surface of the first redistribution layer 111 is connected to a first surface of the third redistribution layer 113 through the first conductive pillar 121, so that the redistribution layers 110 having the same electric property type are ensured to be connected, while an overcurrent capacity between the first redistribution layer 111 and the third redistribution layer 113 is ensured. Referring to FIGs. 12 to 13, the second conductive pillars 122 are divided into four groups of through holes side by side, to connect the second redistribution layer 112 to the fourth redistribution layer 114 having a power property, while the second conductive pillars 122 are substantially distributed on two sides of an orthographic projection of the second conductive layer 102 on the second redistribution layer 112, and uniformly distributed on a second surface of the second redistribution layer 112 and a first surface of the fourth redistribution layer 114, thereby effectively ensuring voltage balance between the second redistribution layer 112 and the fourth redistribution layer 114.

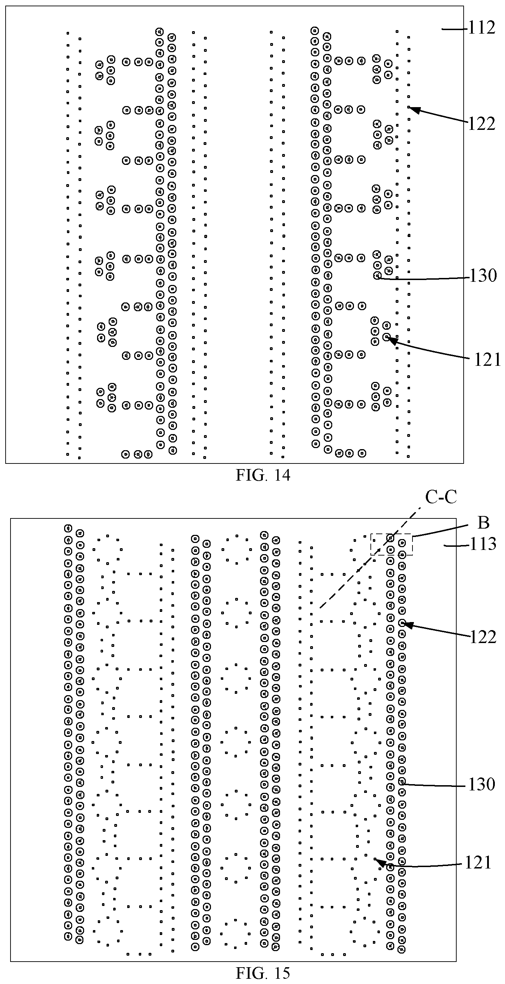

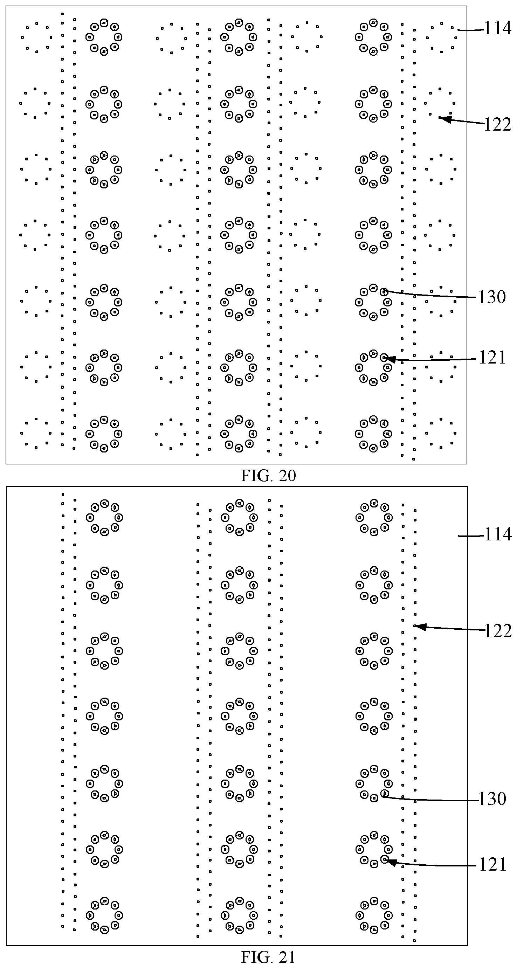

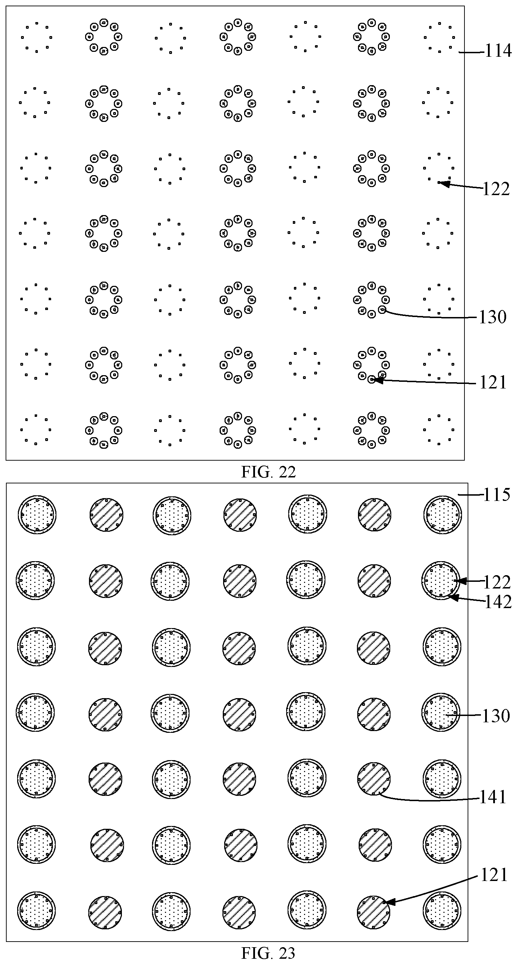

In some embodiments, referring to FIGs. 15 to 19, since the third redistribution layer 113 is located at an intermediate layer of the redistribution layers 110, and both of the first conductive pillars 121 and the second conductive pillars 122 are desired to pass through the third redistribution layer 113, dense holes are arranged in the third redistribution layer 113, and a second surface of the third redistribution layer 113 is connected to a first surface of the fifth redistribution layer 115 through the first conductive pillars 121. In each first conductive layer 101, taking a central axis of the first conductive layer 101 as a center, eight first conductive pillars 121 are formed upward and uniformly distributed within an orthographic projection of the first conductive layer 101 on the third redistribution layer 113, and the first conductive pillars 121 are respectively electrically connected to the second surface of the third redistribution layer 113 and the first surface of the fifth redistribution layer 115. Referring to FIGs. 20 to 22, the first surface of the fourth redistribution layer 114 is electrically connected to a surface of the second conductive pillars 122 away from the second redistribution layer 112, and the second surface of the fourth redistribution layer 114 is directly and electrically connected to a second conductive bump 142 through eight second conductive pillars 122 passing through the fifth redistribution layer 115 in a thickness direction thereof (see FIGs. 23 to 25). Referring to FIGs. 23 to 25, a first conductive bump 141 is electrically connected to the fifth redistribution layer 115 through the first conductive pillars 121. The first conductive pillars 121 and the second conductive pillars 122 are symmetrically and uniformly distributed in each layer of the redistribution layers 110, to ensure voltage balance of each layer of the redistribution layers 110, and thus improve reliability of the redistribution structure 104.

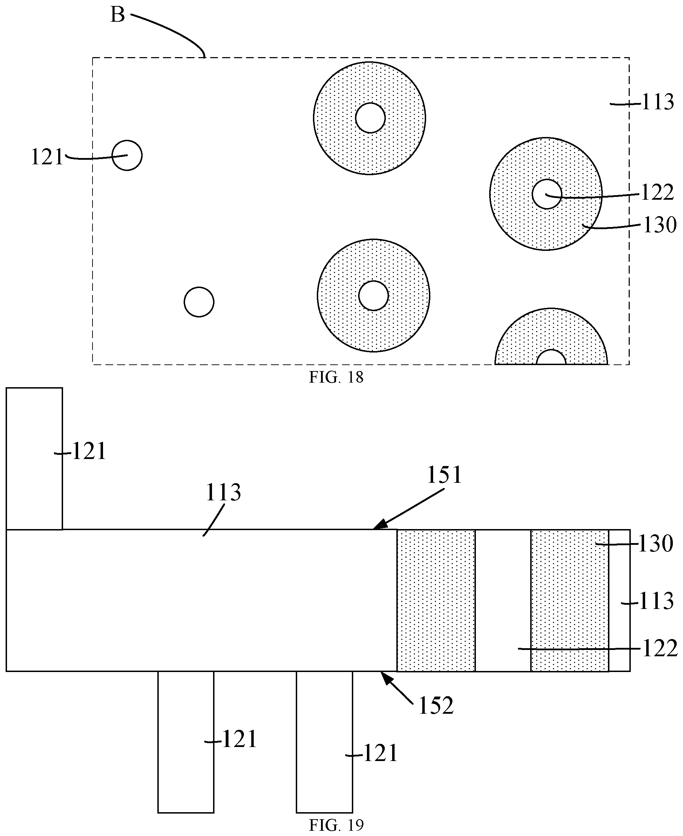

It should be noted that the relationship between the first conductive pillar 121 and the second conductive pillar 122 in each redistribution layer 110 may be as shown in FIGs. 18 and 19. That is, the isolation layer 130 is provided between the first conductive pillars 121 and the redistribution layer 110 having a power property for electrical isolation; and the isolation layer 130 is provided between the second conductive pillars 122 and the redistribution layer 110 having a ground property for electrical isolation. The third redistribution layer 113 has a first surface 151 and a second surface 152 opposite to each other. The first surface 151 faces the substrate, and the second surface 152 faces the conductive bump.

It will be appreciated that the arrangement of the first conductive pillar 121 and the second conductive pillar 122 in the embodiments of the present application is merely an example, and the actual protection scope of the embodiments of the present application may cover any arrangement of the first conductive pillar 121 and the second conductive pillar 122.

The conductive bumps 140 may be used as controlled collapse chip connection bumps (C4 bumps) of the packaging structure, and configured to connect the package substrate and the redistribution layers 110 and output a voltage/current. In some embodiments, adjacent conductive bumps 140 are equally spaced to avoid defects such as warpage and fracture of the redistribution layers 110 caused by stress concentration, and to improve reliability of the redistribution structure 104 while ensuring a current capacity of the power delivery network.

In some embodiments, the conductive bumps 140 include a first conductive bump 141 and a second conductive bump 142. The first conductive bump 141 has a ground property, the second conductive bump 142 has a power property, the first conductive bump 141 is electrically connected to the first conductive layer 101 through the first redistribution layer 111, the third redistribution layer 113, the fifth redistribution layer 115 and the first conductive pillars 121, and the second conductive bump 142 is electrically connected to the second conductive layer 102 through the second redistribution layer 112, the fourth redistribution layer 114 and the second conductive pillars 122. The conductive bumps 140 contact a surface of the first conductive pillars 121 farthest from the substrate, or a surface of the second conductive pillars 122 farthest from the substrate. As shown in FIGs. 6 to 8, the first conductive bump 141 contacts a surface of the first conductive pillars 121 away from the fifth redistribution layer 115, and the second conductive bump 142 contacts a surface of the second conductive pillars 121 away from the fourth redistribution layer 114. In other embodiments, the conductive bumps 140 contact surfaces of the redistribution layers 110, one of the first conductive pillars 121 farthest from the substrate, or one of the second conductive pillars 122 farthest from the substrate. In other words, the first conductive bump 141 direct contacts the fifth redistribution layer 115 for electrical connection, and the second conductive bump 142 contacts a surface of the second conductive pillars 121 away from the fourth redistribution layer 114. Exemplarily, the number of first conductive bumps 141 is equal to the number of second conductive bumps 142.

A ratio of the total number of first conductive layers 101 and second conductive layers 104 to the number of conductive bumps 140 is in a range of 1 to 4, so as to ensure the current capacity of the redistribution layers 110 and a balanced voltage drop of the power of the packaging structure. In some embodiments, as shown in FIGs. 2 to 4, the ratio of the total number of first conductive layers 101 and second conductive layers 104 to the number of conductive bumps 140 is 2. In other embodiments, as shown in FIG. 1, the ratio of the total number of first conductive layers 101 and second conductive layers 104 to the number of conductive bumps 140 is 1. In other words, the number of first conductive layers 101 is the same as the number of first conductive bumps 141, and each of the first conductive layers 101 is electrically connected to one first conductive bump 141, while the number of second conductive layers 102 is the same as the number of second conductive bumps 142, and each second conductive layer 102 is electrically connected to one second conductive bump 142. Orthographic projections of the conductive bump 140 and the first conductive layer 101 or second conductive layer 102 having the same electric property type on the substrate coincide with each other. In still some embodiments, as shown in FIG. 5, the ratio of the total number of first conductive layers 101 and second conductive layers 104 to the number of conductive bumps 140 is 4. For example, eight microbumps are provided, including four first conductive layers 101 and four second conductive layers 102; and two conductive bumps 140 are provided, including one first conductive bump 141 and one second conductive bump 142. In this case, orthographic projections of one second conductive layer 102 and the second conductive bump 142 on the substrate coincide with each other, orthographic projections of another second conductive layer 102 and the first conductive bump 141 on the substrate coincide with each other, and the first conductive layers 101 are located at two sides of the first conductive bump 141. Exemplarily, in the packaging structure provided in the embodiments of the present application, the ratio of the total number of first conductive layers 101 and second conductive layers 104 to the number of conductive bumps 140 is 2.

In some embodiments, the conductive bump 140 may be made of any one or more of aluminum, titanium, or titanium nitride. Aluminum, titanium, or titanium nitride has lower hardness and is easy to operate in the subsequent packaging.

In some embodiments, the packaging structure further includes a polymer layer (not shown) and a package substrate (not shown). The package substrate is electrically connected to the conductive bumps 140, and the polymer layer is located between the insulation layer 103 and the package substrate and wraps the conductive bumps 140. The polymer layer may be used as a stress buffering medium for the packaging process. The polymer layer may be made of bis(phenylene cycloethylene) (BCB), or polyimide (PI). The polymer layer may have a single layer structure or a stacked structure. For example, the polymer layer may include a first polymer layer and a second polymer layer arranged in a stack, where the first polymer layer reinforces the insulation layer 103 of the packaging structure and functions as a stress buffer; and the second polymer layer planarizes a surface of the packaging structure and protects the redistribution structure 104.

In the technical solution provided in the embodiments of the present application, the redistribution layers 110 located at adjacent layers have different electric property types, which means that the redistribution layers 110 of different electric property types are alternately arranged, and the redistribution layers 110 located at the same layer have the same electric property type. In this manner, interlayer crosstalk of different electric property types in the same redistribution layer 110 can be avoided, and the reliability of the redistribution structure 104 can be improved. By alternately arranging the redistribution layers 110 of different electric property types, redistribution layers 110 of a different electric property type are provided between the redistribution layers 110 of the same electric property type, so that the crosstalk between upper and lower surfaces of the redistribution layers 110 is reduced, while an interlayer spacing of the redistribution layers 110 of different electric property types is reduced, thereby facilitating impedance control, interlayer coupling and shielding, favorably reducing the capacitance of the redistribution layers 110, effectively filtering noises to balance the voltage, and improving the reliability of the redistribution structure 104.

In addition, adjacent conductive bumps 140 are equally spaced to avoid defects such as warpage and fracture of the redistribution layers 110 caused by stress concentration, and to improve reliability of the redistribution structure 104 while ensuring a current capacity of the power delivery network.

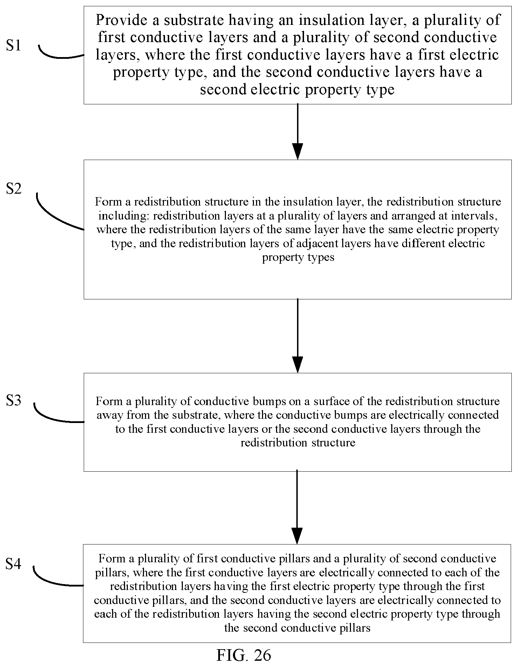

Accordingly, an embodiment of the present application further provides a packaging method for preparing the packaging structure according to any of the above embodiments. FIG. 26 is a schematic flowchart of a packaging method according to an embodiment of the present application.

Referring to FIG. 26, the packaging method may employ a flip-chip process to prepare the packaging structure. The packaging method may include the following operations S1 to S4.

At S1, providing a substrate having an insulation layer 103, a plurality of first conductive layers 101 and a plurality of second conductive layers 102, where the first conductive layers 101 have a first electric property type, and the second conductive layers 102 have a second electric property type.

In operation S1, a plurality of chips are molded into a whole and electrically connected by interconnecting the conductive layers. In other words, the substrate may include initial substrates of a plurality of chips, the insulation layer 103 may include insulation sublayers of the plurality of chips, and the plurality of first conductive layers 101 and the plurality of second conductive layers 102 may be from different chips. Therefore, the first conductive layers 101 and the second conductive layers 102 on different chips may have different spacings.

In some embodiments, the substrate may have a single-layer structure or a stacked structure, and may be provided with electrical devices such as transistors, resistors, or capacitors, while the first conductive layers 101 and the second conductive layers 102 maybe electrically connected to ports of the electrical devices through various conductive structures (not shown). The insulation layer 103 is made of an insulating material, and configured to electrically isolate, and reduce a parasitic capacitance between, the plurality of first conductive layers 101 and the plurality of second conductive layers 102. The insulation layer 103 may be made of any one of silicon oxide, silicon nitride, or silicon carbide.

The first conductive layers 101 and the second conductive layers 102 are alternately arranged at intervals. In some embodiments, the first conductive layers 101 and the second conductive layers 102 are alternately arranged at intervals in a lateral direction, while the same conductive layers are arranged in a longitudinal direction. In other embodiments, the same conductive layers are arranged in the lateral direction, while the first conductive layers 101 and the second conductive layers 102 are alternately arranged at intervals in the longitudinal direction. In still other embodiments, the first conductive layers 101 and the second conductive layers 102 are alternately arranged at intervals in both the lateral direction and the longitudinal direction.

In some embodiments, the first conductive layers 101 and the second conductive layers 102 may be made of the same material, which may be aluminum, tungsten, and copper that have a relatively low self-resistance, which is beneficial to improving the conductivity of the first conductive layers 101 and the second conductive layers 102, and thus is beneficial to improving the conductivity of the first conductive layers 101 and the second conductive layers 102 with the redistribution structure 110.

In some embodiments, the first electric property type is ground property, and the second electric property type is power property. That is, the first conductive layers 101 have a ground property, and the second conductive layers 102 have a power property. In other embodiments, the first electric property type is power property, and the second electric property type is ground property.

At S2, forming a redistribution structure 104 in the insulation layer 103, the redistribution structure 103 including: redistribution layers 110 at a plurality of layers and arranged at intervals, where the redistribution layers 110 located at the same layer have the same electric property type, and the redistribution layers 110 located at adjacent layers have different electric property types.

In operation S2, the redistribution structure 104 further includes: an isolation layer 130 between the redistribution layers 110 located at adjacent layers. The redistribution layers 110 and the isolation layer 130 in a stack may be formed by a vapor deposition process. The redistribution layers 110 include a first redistribution layer 111, a second redistribution layer 112, a third redistribution layer 113, a fourth redistribution layer 114 and a fifth redistribution layer 115 arranged in a stack. The first redistribution layer 111, the third redistribution layer 113 and the fifth redistribution layer 115 have the first electric property type, and the second redistribution layer 112 and the fourth redistribution layer 114 have the second electric property type. In other words, the first redistribution layer 111, the third redistribution layer 113 and the fifth redistribution layer 115 have a ground property, and the second redistribution layer 112 and the fourth redistribution layer 114 have a power property.

At S3, forming a plurality of conductive bumps 140 on a surface of the redistribution structure 104 away from the substrate, where the conductive bumps 140 are electrically connected to the first conductive layers 101 or the second conductive layers 102 through the redistribution structure 104.

In operation S3, a package substrate is provided, and then conductive bumps are formed on a side of the packaging structure facing the substrate, where adjacent conductive bumps 140 are equally spaced to avoid defects such as warpage and fracture of the redistribution layers 110 caused by stress concentration, and to improve reliability of the redistribution structure 104 while ensuring a current capacity of the power delivery network. A ratio of the total number of first conductive layers 101 and second conductive layers 104 to the number of conductive bumps 140 is in a range of 1 to 4, so as to ensure the current capacity of the redistribution layers 110 and a balanced voltage drop of the power of the packaging structure. Exemplarily, in the packaging structure provided in the embodiments of the present application, the ratio of the total number of first conductive layers 101 and second conductive layers 104 to the number of conductive bumps 140 is 2.

In operation S3, a package substrate is provided, a conductive film is formed on a side of the package substrate facing the substrate, and the conductive film is patterned to form a plurality of conductive bumps 140 equally spaced, where the ratio of the total number of first conductive layers 101 and second conductive layers 104 to the number of conductive bumps 140 is 2. The conductive film may be made of any one or more of aluminum, titanium, or titanium nitride. Aluminum, titanium, or titanium nitride has lower hardness and is easy to operate in the subsequent packaging.

At S4, forming a plurality of first conductive pillars 121 and a plurality of second conductive pillars 122, where the first conductive layers 101 are electrically connected to each of the redistribution layers 110 having the first electric property type through the first conductive pillars 121, and the second conductive layers 102 are electrically connected to each of the redistribution layers 110 having the second electric property type through the second conductive pillars 122.

In operation S4, the redistribution layers 110 having the power property in all layers, the second conductive layers 102 and a second conductive bump 142 are firstly electrically connected. In each second conductive layer 102, taking a central axis of the second conductive layer 102 as a center, eight second conductive pillars 122 are formed downward and uniformly distributed on a surface of the second conductive layer 102, and pass through the first redistribution layer 111 in a thickness direction thereof. A side of the second conductive pillars 122 away from the surface of the second conductive layer 102 is electrically connected to a first surface of the second redistribution layer 112. In each second conductive bump 142, taking a central axis of the second conductive bump 142 as a center, eight second conductive pillars 122 are formed upward and uniformly distributed on a surface of the second conductive bump 142, and pass through the fifth redistribution layer 115 in a thickness direction thereof. A side of the second conductive pillars 122 away from the surface of the second conductive bump 142 is electrically connected to a second surface of the fourth redistribution layer 114. Finally, the second conductive pillars 122 are formed to connect the second redistribution layer 112 to the fourth redistribution layer 114, and pass through the third redistribution layer 113 in a thickness direction thereof. The second conductive pillars 122 are divided into four groups of through holes side by side, to connect the second redistribution layer 112 to the fourth redistribution layer 114 having a power property, while the second conductive pillars 122 are substantially distributed on two sides of an orthographic projection of the second conductive layer 102 on the second redistribution layer 112, and uniformly distributed on a second surface of the second redistribution layer 112 and a first surface of the fourth redistribution layer 114, thereby effectively ensuring voltage balance between the second redistribution layer 112 and the fourth redistribution layer 114.

It should be noted that forming the second conductive pillars 122 includes: etching the first redistribution layer 111, the third redistribution layer 113 and the fifth redistribution layer 115 according to an arrangement of the second conductive pillars 122 to form a plurality of first mesopores; forming an isolation layer 130, where the first mesopores are filled with the isolation layer 130; patterning the isolation layer 130 to form a first through hole; and forming the second conductive pillars 122. In other embodiments, the second conductive pillars 122 may be formed by: forming a seed layer, spin-coating and baking a photoresist material layer, and performing a photolithography process (e.g., exposure and development), a plating process (e.g., electroplating or electroless plating), a photoresist stripping process, and a seed layer patterning process.

In operation S4, the redistribution layers 110 having the ground property in all layers, the first conductive layers 101, and a first conductive bump 141 are finally electrically connected. In each first conductive layer 101, taking a central axis of the first conductive layer 101 as a center, eight first conductive pillars 111 are formed downward and uniformly distributed on a surface of the first conductive layer 101. A side of the first conductive pillars 111 away from the surface of the first conductive layer 101 is electrically connected to a first surface of the first redistribution layer 111. The first conductive pillars 111 are formed such that two sides of the first conductive pillars 111 are electrically connected to a surface of the first conductive bump 141 and a second surface of the fifth redistribution layer 115, respectively. The first conductive pillars 111 are formed to connect the first redistribution layer 111 to the third redistribution layer 113 and pass through the second redistribution layer 112 in a thickness direction thereof, and connect the fifth redistribution layer 115 to the third redistribution layer 113 and pass through the fourth redistribution layer 114 in a thickness direction thereof, respectively. Since the third redistribution layer 113 is located in an intermediate layer of the redistribution layers 110, and both of the first conductive pillars 121 and the second conductive pillars 122 are desired to pass through the third redistribution layer 113, dense holes are arranged in the third redistribution layer 113, and a second surface of the third redistribution layer 113 is connected to a first surface of the fifth redistribution layer 115 through the first conductive pillars 121. In each first conductive layer 101, taking a central axis of the first conductive layer 101 as a center, eight first conductive pillars 121 are formed upward and uniformly distributed within an orthographic projection of the first conductive layer 101 on the third redistribution layer 113, and the first conductive pillars 121 are respectively electrically connected to the second surface of the third redistribution layer 113 and the first surface of the fifth redistribution layer 115.

It should be noted that forming the first conductive pillars 121 includes: etching the second redistribution layer 112 and the fourth redistribution layer 115 according to an arrangement of the first conductive pillars 121 to form a plurality of second mesopores; forming an isolation layer 130, where the second mesopores are filled with the isolation layer 130; patterning the isolation layer 130 to form a second through hole; and forming the first conductive pillars 121.

It will be appreciated that the arrangement of the first conductive pillar 121 and the second conductive pillar 122 in the embodiments of the present application is merely shown an example, and the actual protection scope of the embodiments of the present application may cover any arrangement of the first conductive pillar 121 and the second conductive pillar 122. While forming the packaging structure, the conductive bumps 140 may be formed before the redistribution structure 104, the first conductive pillars 121, and the second conductive pillars 122.

After operation S4, the packaging method may further include: forming a polymer layer between the insulation layer 103 and the package substrate and wrapping the conductive bumps 140. The polymer layer may be used as a stress buffering medium for the packaging process. The polymer layer may be made of BCB or PI.

Accordingly, an embodiment of the present application further provides an integrated circuit board which may include the packaging structure according to any of the above embodiments. The integrated circuit board may include, but is not limited to, an analog integrated circuit board and a digital integrated circuit board.

It will be understood by those of ordinary skill in the art that the foregoing implementations are specific embodiments of the present application, and that, in practical applications, various changes in form and details may be made therein without departing from the spirit and scope of the present application. Various changes and modifications may be made by one of ordinary skill in the art without departing from the scope or spirit of the present application, and the scope of the present application should be defined by the appended claims only.

## Claims

1. A packaging structure, comprising:
a substrate having a plurality of first conductive layers (101) and a plurality of second conductive layers (102), wherein the first conductive layers (101) and the second conductive layers (102) have different electric property types, and the electric property types comprise a first electric property type and a second electric property type;
a redistribution structure (104) which is on the substrate and comprises: a plurality of redistribution layers (110) arranged at intervals, wherein the redistribution layers (110) located at a same layer have a same electric property type, and the redistribution layers (110) located at adjacent layers have different electric property types; and wherein the first conductive layers (101) are electrically connected to each of the redistribution layers (110) having the first electric property type through first conductive pillars (121), and the second conductive layers (102) are electrically connected to each of the redistribution layers (110) having the second electric property type through second conductive pillars (122); and
a plurality of conductive bumps (140) on a surface of the redistribution structure (104) away from the substrate, wherein a conductive bump of the plurality of conductive bumps (140) is electrically connected to the first conductive layers (101) or the second conductive layers (102) through the redistribution structure (104).

2. The packaging structure according to claim 1, wherein the conductive bump (140) contacts surfaces of the redistribution layers (110), one or more of the first conductive pillars (121) farthest from the substrate, or one or more of the second conductive pillars (122) farthest from the substrate.

3. The packaging structure according to claim 1, wherein the conductive bump (140) contacts a surface of one or more of the first conductive pillars (121) farthest from the substrate, or a surface of one or more of the second conductive pillars (122) farthest from the substrate.

4. The packaging structure according to any one of claims 1 to 3, wherein a number of layers of the redistribution layers (110) is greater than or equal to 3.

5. The packaging structure according to claim 4, wherein the electric property type of one of the redistribution layers (110) farthest from the substrate is ground property.

6. The packaging structure according to claim 1 or 4, wherein the redistribution layers (110) comprise a first redistribution layer (111), a second redistribution layer (112), a third redistribution layer (113), a fourth redistribution layer (114) and a fifth redistribution layer (115) arranged in a stack, wherein the first redistribution layer (111), the third redistribution layer (113) and the fifth redistribution layer (115) have the first electric property type, and the second redistribution layer (112) and the fourth redistribution layer (114) have the second electric property type; and the first electric property type is ground property, and the second electric property type is power property.

7. The packaging structure according to claim 1, wherein the first conductive layers (101) and the second conductive layers (102) are alternately arranged at intervals.

8. The packaging structure according to claim 1 or 7, wherein a ratio of a total number of the first conductive layers (101) and the second conductive layers (102) to a number of the conductive bumps (140) is in a range of 1 to 4.

9. The packaging structure according to any one of claims 1 to 8, wherein adjacent conductive bumps (140) are equally spaced.

10. An integrated circuit board, comprising: the packaging structure according to any one of claims 1 to 9.
